# FASCICULE DE BREVET EUROPEEN

(11) **EP 2 207 748 B1**
(45) Date de publication et mention de la délivrance du brevet: **22.08.2012**
(21) Numéro de dépôt: 08846382.3
(22) Date de dépôt: 06.11.2008
(51) Int. Cl.: H01L 21/60

(54) **COMPOSANT ELECTRONIQUE A CONNEXIONS PAR BILLES DECOUPLEES MECANIQUEMENT**
ELEKTRONISCHE KOMPONENTE MIT MECHANISCH ENTKOPPELTEN KUGELVERBINDUNGEN
ELECTRONIC COMPONENT WITH MECHANICALLY DECOUPLED BALL-TYPE CONNECTIONS

(30) Priorité: 08.11.2007 FR 0758879
(43) Date de publication de la demande: 21.07.2010
(73) Titulaire: Commissariat à l'Énergie Atomique et aux Énergies Alternatives, 75015 Paris (FR)
(72) Inventeur: CAPLET, Stéphane, F-38360 Sassenage (FR)
(74) Mandataire: Ilgart, Jean-Christophe
(86) Numéro de dépôt international: PCT/EP2008/065055
(87) Numéro de publication internationale: WO 2009/060029

(56) Documents cités:
- DE-A1- 10 360 127
- DE-A1-102004 031 888
- US-A- 5 759 047
- US-A1- 2003 121 698
- US-B2- 7 265 045

## Description

### DOMAINE TECHNIQUE

L'invention concerne le domaine des composants électroniques comportant des puces destinées à être connectées, ou couplées, par « flip-chip » (ou puce retournée), c'est-à-dire par l'intermédiaire de billes, ou microbilles, de connexion, sur un support tel qu'un circuit imprimé électronique.

On entend par puce, ici et dans tout le reste du document, tout élément électronique utilisant des connexions électriques, par exemple un MEMS (microsystème électromécanique), un NEMS (nanosystème électromécanique), un MOEMS (microsystème optoélectromécanique), un imageur ou encore un circuit MOS.

### ÉTAT DE LA TECHNIQUE ANTÉRIEURE

La technique de report par billes, ou microbilles, appelée « flip-chip », consiste à reporter une puce sur un support par l'intermédiaire de plusieurs billes, ou microbilles, disposées sur une face avant de la puce et/ou du support, par exemple en périphérie de cette face. Ces billes sont à base d'un matériau fusible tel qu'un alliage d'or et d'étain.

Pour réaliser le report de la puce sur le support, les billes sont chauffées à une température supérieure ou égale au point de fusion du matériau les constituant. La puce est alors disposée au-dessus du support, les billes formant alors des connexions solides, après refroidissement du matériau fusible, entre la puce et le support.

Lorsque le matériau du support, par exemple un matériau plastique, une résine, ou encore un PCB (polychlorobiphényl), a un coefficient de dilatation thermique différent de celui du matériau de la puce (par exemple du silicium, du verre, etc.), et notamment lorsque la taille de la puce est importante ou que les billes sont de très faibles dimensions, des contraintes mécaniques apparaissent au niveau de ces billes et/ou à l'intérieur de la puce, lors du refroidissement du matériau fusible les constituant. Ces contraintes mécaniques peuvent notamment entraîner un délaminage au niveau de la liaison entre les billes et la puce et/ou entre les billes et le support, fragilisant alors les connexions réalisées entre la puce et le support.

Le document US 2003/121698 A1 décrit un composant électronique comportant une puce et un support, la puce étant destinée à être reportée sur le support et reliée, au niveau d'un emplacement de connexion de la puce formé par une portion d'une couche de la puce, à un emplacement de connexion du support formé par une portion d'une couche du support par une bille. La puce comprend des moyens de découplage mécanique de l'emplacement de connexion de la puce par rapport au support formés par une cavité enterrée et une tranchée réalisées dans la puce.

### EXPOSE DE L'INVENTION

Un but de la présente invention est de proposer un composant électronique comportant au moins une puce et/ou un support, ainsi qu'un procédé de réalisation d'un tel composant, réduisant les contraintes mécaniques, et notamment celles conduisant à des problèmes de délaminage, apparaissant au niveau des billes de connexion lors d'un report de la puce sur le support.

Pour cela, la présente invention propose un composant, par exemple un composant électronique, comportant au moins une puce et/ou un support, la puce étant destinée à être reportée sur le support et reliée, au niveau d'au moins un emplacement de connexion de la puce formé par au moins une portion d'une couche de la puce, à au moins un emplacement de connexion du support formé par au moins une portion d'une couche du support par au moins une bille, la puce et/ou le support comprenant des moyens de découplage mécanique de l'emplacement de connexion de la puce et/ou du support par rapport à la puce et/ou au support, formés par au moins une cavité, par exemple enterrée, réalisée dans la couche de la puce et/ou du support, sous l'emplacement de connexion de la puce et/ou du support, et au moins une tranchée, réalisée dans la couche de la puce et/ou du support, communiquant avec ladite cavité. Ladite tranchée peut entourer en partie ladite portion de la couche tel qu'au moins une zone de ladite couche relie ladite portion de la couche au reste de cette couche et étant à base d'au moins un matériau non métallique. Ladite zone fait alors partie des moyens de découplage mécanique.

Ainsi, on réalise un découplage mécanique au niveau d'un ou plusieurs des emplacements de connexion, ou plots de contact, c'est-à-dire aux emplacements destinés à recevoir les billes de connexion, de la puce et/ou du support. Ce découplage mécanique permet ainsi « d'absorber », ou de compenser, tout ou partie des contraintes mécaniques apparaissant notamment lors du refroidissement du matériau fusible des billes de connexion grâce aux moyens de découplage mécanique formés par une ou plusieurs tranchées et cavités réalisées au niveau du ou des emplacements de connexion, réduisant notamment les risques de délaminage aux niveaux des interfaces entre les billes et le support et/ou entre les billes et la puce. On forme ainsi une zone flexible reliant la portion de la couche, destinée à recevoir la bille de connexion, au reste de cette couche, au niveau d'un ou plusieurs des emplacements de connexion de la puce et/ou du support. Ces zones flexibles forment des zones d'absorption de contraintes mécaniques appelées « poutres ressorts ».

Ce découplage mécanique peut être réalisé au niveau de tous les emplacements de connexion de la puce et/ou du support destinés à recevoir une bille de connexion, ou au niveau d'une partie seulement de ces emplacements. En particulier, le découplage mécanique peut être réalisé au niveau des emplacements critiques, c'est-à-dire ceux qui sont susceptibles de subir les principales contraintes mécaniques lors de l'assemblage de la puce avec le support, tels que ceux se trouvant en périphérie de la puce, à proximité des bords extérieurs de la puce.

L'invention s'applique particulièrement pour des puces dont les dimensions sont par exemple supérieures à environ 5 mm de côté et/ou faisant appel à des billes de connexion de faibles dimensions, par exemple inférieures à environ 100 µm.

Ce découplage mécanique permet également de réaliser un filtrage mécanique des vibrations du composant électronique. En effet, il est possible de calibrer la rigidité de la connexion entre le support et la puce par l'intermédiaire du nombre, de la forme et des dimensions de la ou des tranchées et cavités de découplage réalisées au niveau des emplacements de connexion, ce qui permet d'ajuster la bande passante pour le composant. Par exemple, lorsque l'on veut mesurer une fréquence de résonance du composant à l'intérieur d'une plage de fréquences précise, le découplage mécanique peut permettre de filtrer les fréquences subies ou générées par le composant se trouvant en dehors de cette plage.

La tranchée peut être disposée en périphérie de l'emplacement de connexion de la puce et/ou de l'emplacement de connexion du support.

La tranchée peut faire communiquer la cavité avec une face de la couche de la puce et/ou du support.

La portion de la couche de la puce et/ou la portion de la couche du support peut avoir une forme sensiblement polygonale, par exemple rectangulaire, ou une forme de disque dans un plan parallèle à un plan principal de la couche de la puce et/ou de la couche du support.

La tranchée peut comporter, dans un plan parallèle à un plan principal de la couche de la puce et/ou de la couche du support, par exemple une forme choisie parmi un motif rectangulaire ou un motif d'arc de cercle.

Les moyens de découplage mécanique peuvent comporter, par exemple, au moins quatre tranchées réalisées dans la couche de la puce et/ou la couche du support, faisant communiquer la cavité avec une face de la couche de la puce et/ou de la couche du support.

La tranchée peut comporter au moins un motif de peigne. Ainsi, les moyens de découplage peuvent inclure des motifs de type peigne d'amortissement visqueux, c'est-à-dire comportant une ou plusieurs tranchées formant au moins un peigne d'amortissement, dans lesquelles est disposé un fluide, par exemple une huile, dont la viscosité est telle que le composant ne soit pas résonnant.

La tranchée peut comporter, dans un plan parallèle à un plan principal de la couche de la puce et/ou du support, un motif formé par un ou deux arcs de cercles reliés l'un à l'autre au niveau d'une extrémité.

De façon générale, la forme, les dimensions et le nombre de tranchées utilisées dépendent des applications envisagées et notamment des directions des contraintes subies par chacun des emplacements de connexion de la puce et/ou du support lors du report de la puce sur le support. On peut ainsi réaliser des tranchées aptes à compenser tout ou partie de ces contraintes selon une ou plusieurs directions privilégiées, avec éventuellement un motif spécifique au niveau de chaque emplacement de connexion suivant la force et la direction des contraintes subies au niveau de chaque emplacement de connexion.

Selon l'invention, les moyens de découplage mécanique peuvent comporter en outre au moins un matériau plastique et/ou visqueux disposé dans tout ou partie de la cavité et/ou de la tranchée. Ce matériau plastique et/ou visqueux peut avoir plusieurs fonctions. En particulier, il peut permettre de protéger l'intérieur de la cavité et/ou de la tranchée notamment lors du brasage du matériau fusible de la bille de connexion. Il peut également permettre d'assurer un filtrage mécanique fréquentiel par l'absorption de certaines plages de fréquences, notamment les hautes fréquences dues par exemple à des vibrations parasites. Dans tous les cas, ce matériau plastique et/ou visqueux ne supprime pas la fonction de découplage mécanique assurée par la cavité et la tranchée. A titre d'exemple, un matériau plastique peut être une résine, un matériau visqueux pouvant être par exemple de l'huile. Ce matériau plastique et/ou visqueux fait partie des moyens de découplage mécanique de l'invention. On entend par matériau plastique et/ou visqueux un matériau comportant une capacité de déformation notamment pour ne pas s'opposer au découplage mécanique des emplacements de connexion.

L'emplacement de connexion de la puce et/ou l'emplacement de connexion du support peuvent comporter au moins une portion d'un matériau électriquement conducteur, par exemple à base de métal, disposée sur la portion de la couche de la puce et/ou du support, directement ou par l'intermédiaire d'un matériau d'interface adapté, par exemple du côté de ladite face de la couche.

La portion de matériau conducteur peut former un contact électrique entre au moins deux éléments du composant. Ces éléments peuvent par exemple être des dispositifs microélectroniques, tels que des transistors ou d'autres composants actifs ou passifs, et/ou des MEMS, et/ou NEMS, et/ou MOEMS.

Le composant peut comporter en outre au moins une piste métallique réalisée sur la puce et/ou le support, et reliée électriquement à la portion de matériau conducteur.

La portion de matériau conducteur peut former au moins une partie d'un contact électrique entre la puce et le support.

La puce peut comporter au moins un dispositif de type MOS et/ou au moins un MEMS, et/ou au moins un NEMS, et/ou au moins un MOEMS, par exemple réalisés dans la couche de la puce.

La puce peut être reliée électriquement au support par l'intermédiaire de la bille.

Selon l'invention, les moyens de découplage mécanique peuvent réaliser un filtrage mécanique entre la puce et le support.

La puce peut être réalisée à base d'un matériau dont le coefficient de dilatation thermique est différent de celui d'un matériau à partir duquel est réalisé le support.

Le dispositif électronique peut comporter en outre un matériau englobant le composant, c'est-à-dire la puce et/ou le support, par exemple un polymère ou une résine. Ce matériau permet de protéger le composant sans supprimer la fonction de découplage mécanique assurée par les moyens de découplage mécanique. Le matériau d'enrobage peut être similaire ou non au matériau plastique et/ou visqueux pouvant être disposé dans la tranchée et/ou la cavité.

Le matériau non métallique de ladite zone de la couche, ou zone « poutre-ressort », peut comporter du silicium et/ou de l'oxyde de silicium et/ou du nitrure de silicium.

Le matériau non métallique de ladite zone « poutre-ressort » peut également comporter du silicium dopé dont la résistivité est inférieure à environ 1 Ohm.cm.

La présente invention concerne également un procédé de réalisation d'un composant électronique comportant au moins une puce et/ou un support, la puce étant destinée à être reportée sur le support et reliée, au niveau d'au moins un emplacement de connexion de la puce, à au moins un emplacement de connexion du support par au moins une bille, comportant au moins les étapes de :
- réalisation d'au moins une tranchée dans au moins une première couche, communiquant avec au moins une partie d'une couche sacrificielle disposée contre la première couche.
- suppression de la partie de la couche sacrificielle, formant au moins une cavité disposée sous au moins une portion de la première couche correspondant à l'emplacement de connexion de la puce et/ou l'emplacement de connexion du support,
la tranchée et la cavité formant des moyens de découplage mécanique de l'emplacement de connexion de la puce et/ou de l'emplacement de connexion du support par rapport à la puce et/ou au support.

L'invention concerne également un procédé de réalisation d'un composant comportant au moins une puce et/ou un support, la puce étant destinée à être reportée sur le support et reliée, au niveau d'au moins un emplacement de connexion de la puce, à au moins un emplacement de connexion du support par au moins une bille, comportant au moins les étapes de :
- réalisation d'au moins une tranchée dans au moins une première couche, communiquant avec au moins une partie d'une couche sacrificielle disposée contre la première couche et entourant en partie une portion de la première couche telle qu'au moins une zone de ladite couche relie ladite portion de la couche au reste de cette couche,
- suppression de la partie de la couche sacrificielle, formant au moins une cavité enterrée et disposée sous au moins la portion de la première couche correspondant à l'emplacement de connexion de la puce et/ou l'emplacement de connexion du support,
la tranchée, la cavité et ladite zone de la couche formant des moyens de découplage mécanique de l'emplacement de connexion de la puce et/ou de l'emplacement de connexion du support par rapport à la puce et/ou au support, ladite zone de la couche étant à base d'au moins un matériau non métallique.

Le procédé peut comporter en outre une étape de réalisation d'une portion d'un matériau conducteur disposée sur la portion de la première couche, par exemple du côté d'une face de la première couche communiquant avec la cavité par l'intermédiaire de la tranchée.

Le procédé peut comporter en outre, entre l'étape de suppression de la partie de la couche sacrificielle et une étape de report de la puce sur le support, une étape de remplissage de la cavité et/ou de la tranchée par un matériau plastique et/ou visqueux.

Le procédé peut comporter en outre, après une étape de report de la puce sur le support, une étape de dépôt d'une résine d'enrobage sur le composant électronique.

La présente invention peut également concerner un procédé de filtrage mécanique entre au moins un support et une puce, tel que décrit précédemment, couplée au support.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une vue de dessus d'une puce à emplacements de connexion découplés mécaniquement, objet de la présente invention, selon un premier mode de réalisation,
- les figures 2 et 3A représentent respectivement une vue en coupe et une vue de dessus d'un premier exemple d'emplacement de connexion découplé mécaniquement d'une puce,
- la figure 3B représente une vue de dessus d'une variante du premier exemple d'emplacement de connexion découplé mécaniquement d'une puce,
- la figure 4A représente une vue de dessus d'un second exemple d'emplacement de connexion découplé mécaniquement d'une puce,
- la figure 4B représente une vue de dessus partielle d'une variante du second exemple d'emplacement de connexion découplé mécaniquement d'une puce,
- les figures 5 à 7 représentent les étapes d'un procédé de réalisation d'une puce à emplacements de connexion découplés mécaniquement, objet de la présente invention, selon un second mode de réalisation,
- les figures 8 et 9A représentent des vues en coupe d'une puce à emplacements de connexion découplés mécaniquement, objet de la présente invention, selon un troisième mode de réalisation,
- la figure 9B représente une vue de dessus en coupe d'une puce à emplacements de connexion découplés mécaniquement, objet de la présente invention, selon le troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

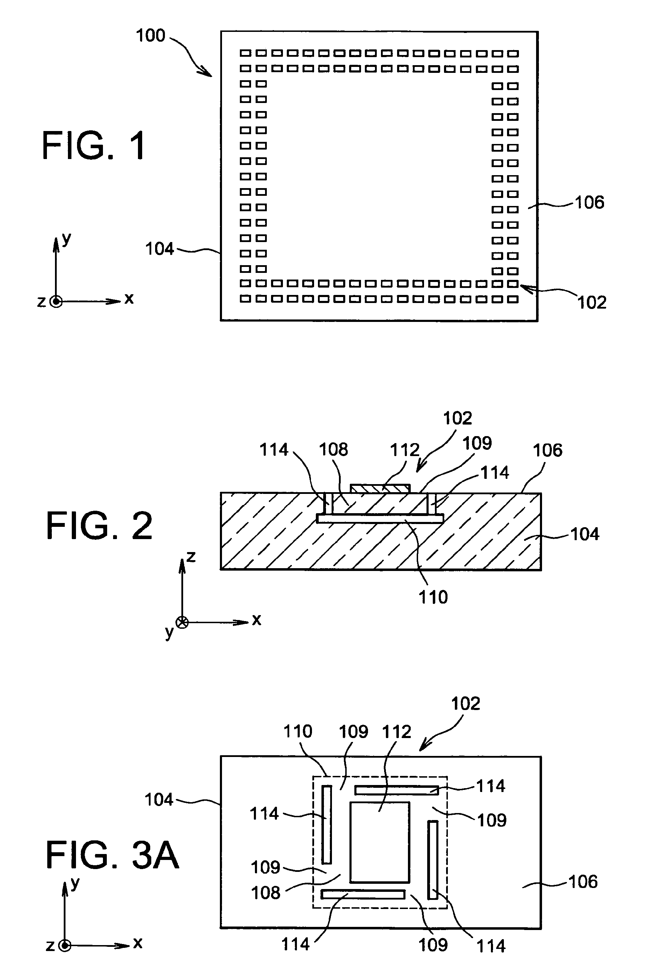

On se réfère tout d'abord à la figure 1 qui représente un exemple d'une puce 100 comportant une pluralité d'emplacements de connexion 102 selon un premier mode de réalisation. Les figures 2 et 3A représentent respectivement une vue en coupe et une vue de dessus d'un premier exemple d'un de ces emplacements de connexion 102.

La puce 100 comporte une couche 104, par exemple à base d'au moins un semi-conducteur tel que du silicium. Cette couche 104 peut notamment être une couche active de la puce 100. Un ou plusieurs dispositifs microélectroniques tels que des dispositifs MOS ou des MEMS, non représentés, peuvent notamment être réalisés sur cette couche active 104. Les emplacements de connexion 102 sont ici réalisés sur une face 106 de la couche active 104. Dans l'exemple de la puce 100 représentée sur la figure 1, les emplacements de connexion 102 sont réalisés en périphérie de la couche active 104, c'est-à-dire proche des bords extérieurs de la couche 104, selon un motif formant deux rectangles concentriques.

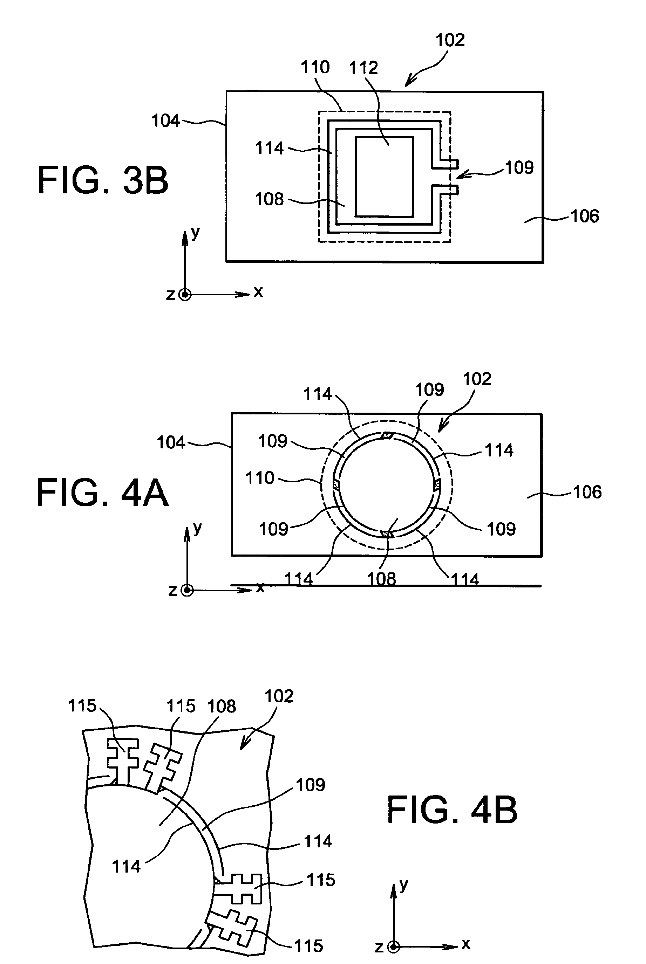

Chaque emplacement de connexion 102 est formé par une portion 108 de la couche active 104. Une cavité 110, ici enterrée dans la couche 102, est réalisée sous chacune des portions 108 de la couche active 104. Chaque portion 108 peut être délimitée, dans un plan parallèle au plan (x,y), plan principal de la couche active 104, du reste de la couche active 104 par le motif de la cavité 110. Sur l'exemple des figures 2 et 3, la cavité 110 a une forme rectangulaire.

Chaque emplacement de connexion 102 comporte également une portion 112 d'un matériau conducteur, par exemple un métal tel que de l'or, destinée à recevoir une bille de connexion. Chaque emplacement de connexion 102 peut également comporter une couche de métallisation sous plots (UMB pour «Under Bump Metallization »), non représentée sur les figures décrites ici, sur la portion 112. Sur l'exemple des figures 2 et 3A, la portion conductrice 112 est centrée par rapport au centre de la cavité 110. Enfin, des tranchées 114, ici au nombre de quatre et de forme rectangulaire, sont réalisées dans la portion 108, faisant communiquer la cavité 110 avec la face extérieure 106 de la couche active 104. Sur l'exemple d'emplacement 102 décrit en liaison avec les figures 2 et 3A, les tranchées 114 sont réalisées en périphérie de la portion 108, entourant cette portion 108, et sont parallèles deux à deux. Chaque tranchée 114 forme, dans un plan parallèle au plan (x,y) un rectangle dont le plus grand côté est parallèle avec un des côtés du rectangle formé par la cavité 110 dans un plan parallèle au plan (x,y). La cavité 110 et les tranchées 114 forment donc ici des moyens de découplage mécanique de l'emplacement de connexion 102 par rapport à la puce 100.

Sur la figure 3A, on voit que les tranchées 114 n'entourent qu'en partie la portion 108. Des zones 109, appelées zones poutres-ressorts, chacune se trouvant entre deux tranchées 114, relient la portion 108 au reste de la couche 104. Ainsi, les zones 109 poutres-ressorts sont aptes à réaliser une absorption mécanique des contraintes pouvant apparaitre au niveau de la portion 108 grâce au découplage mécanique réalisé entre la portion 108 et le reste de la couche active 104.

De plus, on peut réaliser la puce 100 tel que ces zones poutres-ressorts 109 soient formées dans la couche active 104 dont le matériau prédominant, c'est-à-dire formant une grande partie de la couche 104, peut être un matériau apte à absorber de fortes contraintes mécaniques sans casser. Il est ainsi possible de dimensionner des zones poutres-ressorts 109(c'est-à-dire la distance entre deux tranchées 114 qui délimite l'une des zones 109, et l'épaisseur de la portion 108) offrant une grande souplesse mécanique dans le plan (x,y) mais également selon l'axe z, c'est-à-dire pouvant par exemple se déformer de quelques dizaines de micromètres, par exemple jusqu'à 50 ou 90 µm, sans casser. Un tel matériau, qui est non métallique, peut être du silicium, par exemple monocristallin, de l'oxyde de silicium, ou du nitrure de silicium, ou encore du silicium dopé.

La figure 3B représente une variante du premier exemple d'emplacement de connexion 102. Par rapport à la figure 3A, une seule tranchée 114 est réalisée en périphérie de la portion 108. Par rapport à la figure 3A, la portion 108 est donc reliée au reste de la couche 104 au niveau d'une seule zone 109 apte à absorber les contraintes selon la direction du vecteur y représenté sur la figure 3B.

La figure 4A représente une vue de dessus d'un second exemple d'emplacement de connexion 102 découplé mécaniquement de la puce 100. Par rapport au premier exemple des figures 2, 3A et 3B, ce second exemple comporte une cavité 110 de forme cylindrique. La portion 108 de la couche active 104 est également de forme cylindrique. Dans ce second exemple d'emplacement de connexion 102, quatre tranchées 114 sont réalisées dans la portion 108, faisant communiquer la cavité 110 avec la face 106 de la couche active 104. Par rapport au premier exemple des figures 2 et 3, chaque tranchée 114 a ici un motif, dans un plan (x,y), formé par deux arc de cercles reliés l'un à l'autre au niveau d'une extrémité par un parallélogramme. Ces deux arcs de cercle sont disposés sur deux cercles de diamètres distincts ayant, dans cet exemple, pour centre celui de la cavité 110. Des zones 109 poutres-ressorts, c'est-à-dire des zones d'absorption de contraintes mécaniques, se trouvent entre deux arcs de cercles de deux tranchées 114 voisines. Une portion de matériau conducteur, non représentée sur l'exemple de la figure 4A, peut également être disposée sur la portion 108 de la couche active 104.

La figure 4B représente une vue de dessus partielle d'une variante du second exemple d'emplacement de connexion 102 décrit précédemment en liaison avec la figure 4A. Dans cette variante, chaque tranchée 114 a un motif, dans un plan (x,y), formé par deux arcs de cercles reliés l'un à l'autre au niveau d'une extrémité par au moins un peigne interdigité, par exemple deux peignes interdigités 115 comme représenté sur la figure 4B.

De manière générale, le nombre de tranchées réalisées dans la couche active, la forme de ces tranchées et le motif général formé par les tranchées peuvent être différents des exemples décrits précédemment. Il est également possible que le découplage mécanique d'un emplacement de connexion soit formé en partie par plusieurs cavités réalisées dans la couche 104.

Lors de la connexion de la puce 100 sur un support, par exemple sur un circuit imprimé (ou PCB pour « Printed Circuit Board »), des billes de connexion sont déposées, ou formées par dépôt et refonte, sur les emplacements de connexion 102, notamment sur les portions conductrices 112. Ces billes de connexions sont réalisées à base d'un matériau fusible tel qu'un alliage d'or et d'étain, ou d'étain et de plomb, ou encore d'indium et d'étain. Elles sont chauffées à une température supérieure ou égale au point de fusion du matériau fusible, puis, en refroidissant, le matériau fusible redevient solide, soudant ainsi les billes aux portions conductrices 112. La puce 100 peut alors être connectée au circuit imprimé en la plaçant contre le circuit imprimé par l'intermédiaire des billes de connexion, puis en réalisant un brasage des billes entre la puce 100 et le circuit imprimé. Il est également possible que les billes soient tout d'abord placées sur le circuit imprimé, puis que la puce 100 soit connectée au circuit imprimé en réalisant un brasage des billes de connexion. Il est également possible que des billes de connexion soient réparties à la fois sur la puce et sur le support avant de réaliser la connexion de la puce sur le support.

Les cavités 110, les tranchées 114 et les zones poutres-ressorts 109 réalisent un découplage mécanique au niveau de chaque emplacement de connexion 102. En effet, si le matériau du circuit imprimé, ou plus généralement le matériau du support sur lequel est destiné à être connecté la puce 100 par flip-chip, a un coefficient de dilatation thermique différent de celui de la couche 104 (par exemple : coefficient de dilatation thermique du silicium = 3 ppm/°C ; coefficient de dilatation thermique de la résine du circuit imprimé = 19 ppm/°C), les contraintes mécaniques subies par les billes de connexions sont alors dissipées grâce à ce découplage mécanique, supprimant en particulier le risque de délaminage des billes de connexions lors du refroidissement du métal.

Dans l'exemple de réalisation décrit en liaison avec la figure 1, tous les emplacements de connexion 102 sont réalisés selon l'exemple décrit en relation avec les figures 2, 3A et 3B ou celui de l'une des figures 4A ou 4B, c'est-à-dire que chacun d'eux comporte une ou plusieurs cavités, une ou plusieurs tranchées et des zones poutres-ressorts reliant la portion formant l'emplacement de connexion au reste de la couche active, formant des moyens de découplage mécanique. Toutefois, il est possible qu'une partie seulement des emplacements de connexion 102 comporte ces éléments de découplage mécanique, les autres emplacements de connexion 102 ne comportant pas de tranchées ni de cavité réalisée sous la portion de couche active formant l'emplacement de connexion. Par exemple, seuls les emplacements de connexions « critiques » peuvent comporter ces éléments de découplage mécanique. Sur l'exemple de la figure 1, il est possible que seuls les emplacements de connexion formant le rectangle le plus proche des bords extérieurs de la couche 104 peuvent par exemple comporter les éléments de découplage mécanique.

De plus, dans les exemples décrits précédemment, seuls les emplacements de connexion de la puce sont découplés mécaniquement. Or, dans une variante, tous les emplacements de connexion du support, ou une partie de ces emplacements de connexion, destinés recevoir les billes de connexions peuvent être découplés mécaniquement du support. Ce découplage mécanique des emplacements de connexion du support est réalisé de manière similaire aux exemples décrits précédemment (réalisation d'une ou plusieurs cavités et tranchées dans la couche du support). Ainsi, le découplage mécanique des emplacements de connexion peut être réalisé au niveau du support et/ou de la puce.

Les portions conductrices 112 peuvent également réaliser des plots de contact électrique permettant, par exemple, la circulation de signaux électriques entre la puce 100 et le support sur lequel est connecté la puce 100 par l'intermédiaire des billes de connexion et/ou entre différents éléments de la puce 100 et/ou du support par l'intermédiaire de pistes métalliques réalisées sur la puce 100 et/ou sur le support, et reliées aux portions conductrices 112. Ces pistes peuvent notamment relier différents éléments de la puce 100 entre eux, par exemple des dispositifs microélectroniques et/ou des MEMS. Des pistes métalliques d'interconnexions peuvent également être réalisées du côté du support ne comportant pas la puce 100 et/ou être enterrées dans la couche 104 de la puce 100 ou dans le support.

Outre leur fonction de découplage mécanique, les tranchées 114, les cavités 110 réalisées dans la couche active 104 et les zones poutres-ressorts 109 peuvent également réaliser un filtrage mécanique. Ce filtrage est par exemple utile si l'on souhaite mesurer une fréquence de résonance de la puce ou d'un composant réalisé sur la puce, qui peut être un MEMS, dans une certaine plage de fréquences. Dans ce cas, en calibrant la rigidité de la connexion entre la puce et le support sur lequel est reporté la puce par l'intermédiaire de la géométrie des tranchées et des cavités, et en ajoutant éventuellement une fonction d'amortissement grâce à l'introduction d'un matériau plastique et/ou visqueux dans la ou les tranchées et cavités, on peut alors filtrer les fréquences se trouvant au-delà de la plage de fréquences dan laquelle on souhaite réaliser la mesure, et ainsi éviter par exemple des phénomènes de résonance parasites de la puce 100. Pour créer un amortissement de type visqueux, il est possible de jouer sur la plasticité ou la viscosité du matériau, par exemple de l'huile, disposé dans les tranchées. Lorsque l'on remplie les tranchées et non la cavité, on utilise un matériau donné, par exemple une résine, et on joue sur la largeur des tranchées. Dans le cas d'un remplissage des tranchées et de la cavité, on utilise de préférence un fluide, par exemple une huile.

Après l'étape de report de la puce 100 sur le circuit imprimé, il est possible de déposer une résine englobant l'ensemble formé par la puce 100 reportée et le support. Cette résine peut notamment remplir les tranchées et/ou les cavités réalisées au niveau des emplacements de connexion 102. Dans ce cas, la résine est choisie telle qu'elle puisse faire office d'absorbeur (ou amortisseur) des vibrations subies par la puce et/ou le support. Ce matériau peut être une résine d'enrobage. Lorsqu'un fluide est disposé dans la ou les tranchées et/ou dans la ou les cavités formant des moyens de découplage mécanique, on réalise de préférence un enrobage de l'ensemble puce et support pour contenir ce fluide dans son emplacement.

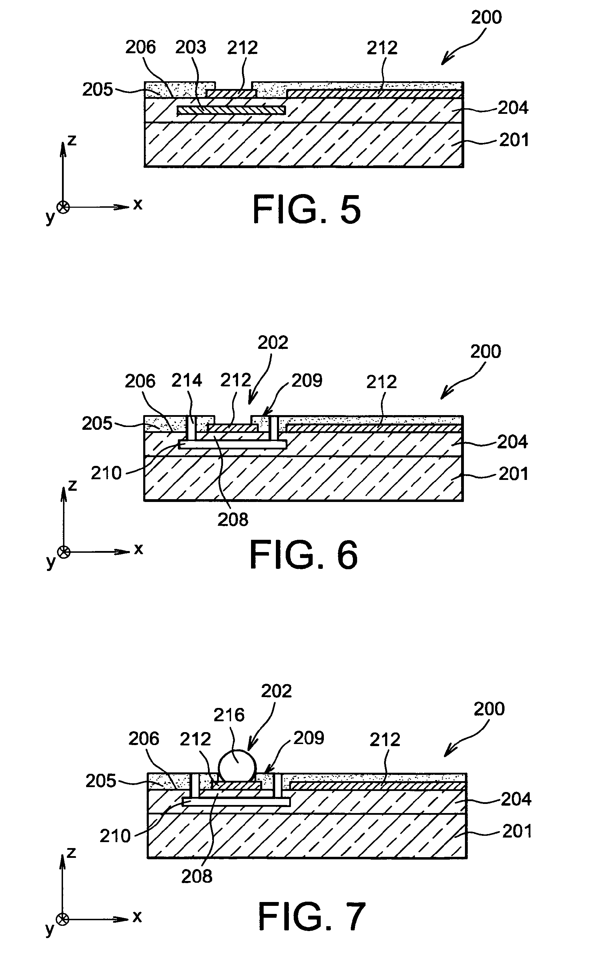

On se réfère maintenant aux figures 5 à 7 représentant les étapes d'un procédé de réalisation d'une puce 200 à emplacements de connexion découplés mécaniquement selon un second mode de réalisation.

Dans cet exemple de réalisation, la puce 200 est réalisée par exemple en technologie CMOS à partir d'un substrat de silicium 201, sur lequel est disposée une couche d'interconnexion métallique 204 à base d'oxyde de silicium et de métal. Des dispositifs CMOS, non représentés, et les couches d'interconnexions métalliques sont réalisés selon un procédé CMOS standard. Sur la figure 5, une partie d'une couche métallique inférieure 203 et une partie d'une couche métallique supérieure 212 sont notamment représentées. Enfin, une couche de passivation 205, par exemple à base de nitrure de silicium, peut être déposée sur une face 206 de la couche 204 et sur la couche métallique supérieure 212 se trouvant également sur la face 206 de la couche 204. Cette couche de passivation 205 peut comporter une ouverture au niveau du métal 212. De plus, une couche supplémentaire UBM peut aussi être déposée sur la couche de passivation 205 et/ou sur la couche métallique 212.

Comme représenté sur les figures 6 et 7, on réalise les emplacements de connexion 202 de la puce 200 sur la face 206 de la couche 204. Comme pour la puce 100 décrite précédemment, les emplacements de connexion 202 sont réalisés de préférence en périphérie de la couche 204, c'est-à-dire à proximité des bords extérieurs de la couche 204.

Pour cela, on réalise une lithographie et une gravure de tranchées 214, par exemple de géométrie similaire à celle des tranchées 114 décrites précédemment, dans la couche active 204 et la couche de passivation 205. Ces tranchées 214 forment un accès à un motif isolé de la couche métallique inférieure 203 qui est ici utilisée en tant que couche sacrificielle. On grave alors la portion de la couche métallique inférieure 203 pour former une cavité 210 sous une portion 208 de la couche 204. Des zones 209, reliant la portion 208 au reste de la couche 204, sont obtenues dans les couches 204 et 205, formant des zones poutres-ressorts analogues aux zones 109 précédemment décrites. Cette gravure sacrificielle peut être réalisée par gravure humide, par exemple de type HCl (chlorure d'hydrogène). Comme pour la puce 100 décrite précédemment, la cavité 210 délimite, dans un plan parallèle au plan (x,y), la portion 208 formant un emplacement de connexion par rapport au reste de la couche active 204 et de la couche de passivation 205. Dans une variante, les zones 209 peuvent être formées uniquement dans la couche 204. Dans ce cas, la couche de passivation 205 est préalablement ouverte, par exemple par gravure, à l'emplacement des zones 209.

Le report de la puce 200, par exemple sur un circuit imprimé, peut alors être similaire à celui décrit pour la puce 100. La cavité 210 et les tranchées 214 réalisent alors un découplage mécanique au sein de l'emplacement de connexion 202.

Comme pour la puce 100 décrite précédemment, les portions conductrices 212 peuvent former une ligne de contact électrique entre l'emplacement de connexion et le reste de la puce 200 pour acheminer des signaux électriques. De préférence, ces lignes de contact électrique sont recouvertes par la couche de passivation 205. Il est également possible de réaliser une fonction de filtrage mécanique par l'intermédiaire des tranchées, cavités et zones poutres-ressorts réalisées au niveau des emplacements de connexion de la puce 200 et/ou en remplissant les tranchées et la cavité au moins partiellement par un matériau plastique et/ou visqueux et/ou en déposant une résine englobant l'ensemble de la puce 200. Cette fonction de filtrage peut également être réalisée lorsque qu'aucun matériau ou fluide n'est déposé dans la cavité ou la tranchée, l'air présent dans la tranchée et la cavité réalisant déjà un amortissement des vibrations subies par la puce et/ou le support.

Lorsqu'un découplage mécanique est réalisé sur le support, celui-ci peut être formé par plusieurs couches, dont par exemple une couche inférieure à base de métal est utilisée en tant que couche sacrificielle pour la réalisation d'une cavité, de manière analogue à la réalisation de la cavité de découplage mécanique réalisée précédemment dans la puce.

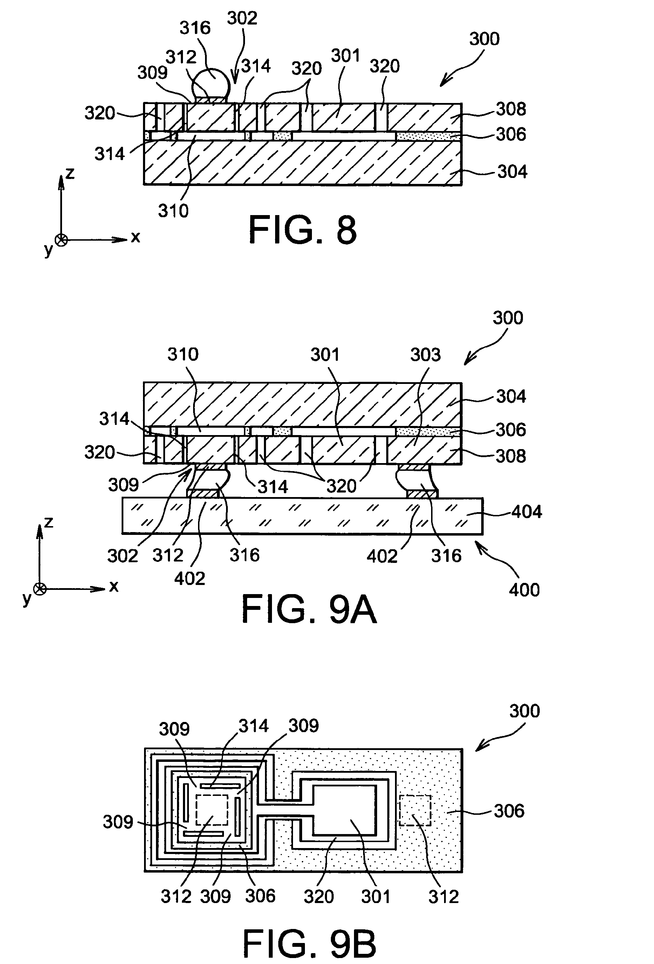

Les figures 8, 9A et 9B représentent un autre exemple de puce 300 comportant des emplacements de connexion 302 découplés mécaniquement selon un troisième mode de réalisation.

Cette puce 300 comporte notamment un MEMS 301 réalisé sur un substrat SOI formé par une couche 304 par exemple à base de silicium, une couche diélectrique 306, par exemple de l'oxyde de silicium, et une couche active 308 à base de silicium. Ce MEMS 301 est par exemple un accéléromètre, un gyromètre ou un capteur de pression. Le silicium de la couche active 308 peut être suffisamment conducteur pour faire passer un signal électrique entre le MEMS 301 et un emplacement de connexion 302. Pour cela, ce silicium peut être dopé par du bore ou du phosphore pour obtenir une résistivité inférieure à quelques ohm.cm (par exemple inférieure à 9 ohm.cm ou 5 ohm.cm). De plus, le niveau de dopage peut être choisi le plus grand possible tout en restant en deçà de la limite de dégénérescence du matériau pour conserver une bonne qualité mécanique de la structure cristalline du silicium, soit une résistivité par exemple comprise entre environ 1 milliOhm.cm et 900 milliOhm.cm. Des tranchées d'isolation 320, réalisant une isolation électrique et/ou mécanique suivant le type de MEMS, séparent en partie le MEMS 301 du reste de la couche active 308. La figure 9B représente une vue de dessus en coupe dans le plan de la couche diélectrique 306 de cette puce 300. La couche active 308 a par exemple une épaisseur comprise entre environ 1 µm et 1 mm.

Des tranchées 314, par exemples similaires aux tranchées 114 et 214 décrites précédemment, de découplage mécanique sont réalisées dans le MEMS 301. Une cavité 310, réalisée sous le MEMS 301, forme également une cavité de découplage mécanique de l'emplacement de connexion 302. De plus, des zones 309 de découplage mécanique, formant des zones poutres-ressorts sensiblement analogues aux zones 109 et 209, contribuent au découplage mécanique de l'emplacement de connexion 302. De façon avantageuse, les tranchées 314 peuvent être réalisées par gravure DRIE (gravure ionique réactive profonde).

Une portion d'un matériau conducteur 312 est réalisée sur le MEMS 301 et est destinée à réaliser la reprise de contact du silicium et aussi à recevoir une première bille de connexion 316. L'emplacement découplé mécaniquement est donc ici formé par une partie du MEMS 301. Comme représenté sur la figure 9A, la puce 300 est connectée à un support 400 formé par une couche 404 par l'intermédiaire des billes de connexion 316 préalablement réalisées sur la puce 300 et/ou sur le support 400. Sur l'exemple de la figure 9A, des emplacements de connexion 402 recevant les billes de connexion 316 ne sont pas découplés mécaniquement contrairement à l'emplacement de connexion 302 formé dans la puce 300. Mais dans une variante de réalisation, ces emplacements de connexion 402 peuvent être découplés mécaniquement par au moins une tranchée et au moins une cavité formée dans la couche 404 du support 400, par exemple de manière similaire à la réalisation des tranchées et cavités formées dans la puce décrite précédemment. Sur la figure 9A, une seconde bille 316 est représentée, reliant la couche active 308 au support 400. Dans ce troisième mode de réalisation, on a un emplacement de connexion 303 réalisé sur le MEMS 301 qui n'est pas découplé mécaniquement. De manière générale, les emplacements de connexion peuvent être réalisés sur des parties « passives » de la couche, c'est-à-dire sur des parties ne comportant pas de dispositif actif, et/ou sur des parties actives comme par exemple le MEMS 301.

L'assemblage de la puce 300 sur le circuit imprimé 400, peut être similaire à celui décrit pour la puce 100. La cavité 310 et les tranchées 314 réalisent alors un découplage mécanique au sein de l'emplacement de connexion 302 de la puce 300 représentée sur les figures 8, 9A et 9B.

Comme pour les puces 100 et 200 décrites précédemment, les portions conductrices 312 peuvent également former, en plus de leur fonction de liaison mécanique, des plots de contact d'acheminement de signaux électriques. Il est également possible que les tranchées 314 et la cavité 310 soient remplies par un matériau ou un fluide assurant une fonction d'amortissement des contraintes subies au niveau de l'emplacement de connexion 302. Une résine peut également englober l'ensemble du composant formé par la puce 300 et le support 400. La puce 300 peut également être protégée par un capot hermétique, par exemple un capot pyrex avec scellement anodique, notamment lorsque l'on souhaite que la puce soit disposée dans un environnement sous vide.

## Revendications

1. Composant comportant au moins une puce (100, 200, 300) destinée à être reportée sur un support (400) et reliée, au niveau d'au moins un emplacement de connexion (102, 202, 302) de la puce formé par au moins une portion (108, 208) d'une couche (104, 204, 308) de la puce, à au moins un emplacement de connexion (402) du support formé par au moins une portion d'une couche (404) du support, par au moins une bille (216, 316), la puce comprenant des moyens de découplage mécanique de l'emplacement de connexion (102, 202, 302) de la puce par rapport à la puce, **caractérisé en ce que** les moyens de découplage mécanique sont formés par au moins une cavité (110, 210, 310) enterrée et réalisée dans une couche sacrificielle (203, 306), correspondant à une couche diélectrique d'un substrat SOI ou une couche métallique, disposée contre la couche (104, 204, 308) de la puce, sous ledit emplacement de connexion (102, 202, 302), et au moins une tranchée (114, 214, 314), réalisée dans ladite couche (104, 204, 308), communiquant avec ladite cavité (110, 210, 310) et entourant en partie ladite portion (108, 208) de la couche (104, 204, 308) tel qu'au moins une zone (109, 209, 309) de ladite couche relie ladite portion (108, 208) de la couche au reste de cette couche, ladite zone (109, 209, 309) étant à base d'au moins un matériau non métallique.

2. Composant comportant au moins un support (400) sur lequel est destinée à être reportée au moins une puce (100, 200, 300) reliée, au niveau d'au moins un emplacement de connexion (102, 202, 302) de la puce formé par au moins une portion (108, 208) d'une couche (104, 204, 308) de la puce, à au moins un emplacement de connexion (402) du support formé par au moins une portion d'une couche (404) du support, par au moins une bille (216, 316), le support comprenant des moyens de découplage mécanique de l'emplacement de connexion (402) du support par rapport au support, **caractérisé en ce que** les moyens de découplage mécanique sont formés par au moins une cavité (110, 210, 310) enterrée et réalisée dans une couche sacrificielle (203, 306), correspondant à une couche diélectrique d'un substrat SOI ou une couche métallique, disposée contre la couche (404) du support, sous ledit emplacement de connexion (402), et au moins une tranchée (114, 214, 314), réalisée dans ladite couche (404), communiquant avec ladite cavité (110, 210, 310) et entourant en partie ladite portion (108, 208) de la couche (404) tel qu'au moins une zone (109, 209, 309) de ladite couche relie ladite portion (108, 208) de la couche au reste de cette couche, ladite zone (109, 209, 309) étant à base d'au moins un matériau non métallique.

3. Composant selon les revendications 1 et 2, la puce (100, 200, 300) et le support (400) comportant des emplacements de connexion (102, 202, 302, 402) découplés mécaniquement.

4. Composant selon l'une des revendications précédentes, la tranchée (114, 214, 314) étant disposée en périphérie de l'emplacement de connexion (102, 202, 302) de la puce (100, 200, 300) et/ou de l'emplacement de connexion (402) du support (400).

5. Composant selon l'une des revendications précédentes, la tranchée (114, 214, 314) faisant communiquer la cavité (110, 210, 310) avec une face (106, 206) de la couche (104, 204, 308, 404) de la puce et/ou du support.

6. Composant selon l'une des revendications précédentes, la portion (108, 208) de la couche (104, 204, 308) de la puce (100, 200, 300) et/ou la portion de la couche (404) du support (400) ayant une forme sensiblement polygonale ou une forme de disque dans un plan parallèle à un plan principal de la couche (104, 204, 308) de la puce et/ou de la couche (404) du support (400).

7. Composant selon l'une des revendications précédentes, la tranchée (114, 214, 314) comportant, dans un plan parallèle à un plan principal de la couche (104, 204, 308) de la puce et/ou de la couche (404) du support (400), une forme choisie parmi un motif rectangulaire ou un motif d'arc de cercle.

8. Composant selon l'une des revendications précédentes, les moyens de découplage mécanique comportant au moins quatre tranchées (114, 214, 314) réalisées dans la couche (104, 204, 308) de la puce et/ou la couche (404) du support, faisant communiquer la cavité (110, 210, 310) avec une face (106, 206) de la couche (104, 204, 308) de la puce et/ou de la couche (404) du support.

9. Composant selon l'une des revendications précédentes, la tranchée comportant au moins un motif de peigne.

10. Composant selon l'une des revendications précédentes, les moyens de découplage mécanique comportant en outre au moins un matériau plastique et/ou visqueux disposé dans au moins une partie de la tranchée (114, 214, 314) et/ou de la cavité (110, 210, 310).

11. Composant selon l'une des revendications précédentes, l'emplacement de connexion (102, 202, 302) de la puce (100, 200, 300) et/ou l'emplacement de connexion (402) du support (400) comportant au moins une portion (112, 212, 312) d'un matériau électriquement conducteur disposée sur la portion (108, 208, 302) de la couche (104, 204, 308, 404) de la puce et/ou du support.

12. Composant selon la revendication 11, la portion (112, 212, 312) de matériau conducteur formant un contact électrique entre au moins deux éléments du composant.

13. Composant selon l'une des revendications 11 ou 12, comportant en outre au moins une piste métallique réalisée sur la puce (100, 200, 300) et/ou le support (400) et reliée électriquement à la portion (112, 212, 312) de matériau conducteur.

14. Composant selon l'une des revendications 11 à 13, la portion (112, 212, 312) de matériau conducteur formant au moins une partie d'un contact électrique entre la puce (100, 200, 300) et le support (400).

15. Composant selon l'une des revendications précédentes, la puce (100, 200, 300) comportant en outre au moins un dispositif de type MOS et/ou au moins un MEMS, et/ou au moins NEMS, et/ou au moins un MOEMS (301).

16. Composant selon l'une des revendications précédentes, la puce (100, 200, 300) étant reliée électriquement au support (400) par l'intermédiaire de la bille (216, 316).

17. Composant selon l'une des revendications précédentes, les moyens de découplage mécanique réalisant un filtrage mécanique entre la puce (100, 200, 300) et le support (400).

18. Composant selon l'une des revendications précédentes, la puce (100, 200, 300) étant réalisée à base d'un matériau dont le coefficient de dilatation thermique est différent de celui d'un matériau à partir duquel est réalisé le support (400).

19. Composant : selon l'une des revendications précédentes, comportant en outre un matériau englobant la puce (100, 200, 300) et/ou le support (400).

20. Composant selon l'une des revendications précédentes, le matériau non métallique de ladite zone (109, 209, 309) comportant du silicium et/ou de l'oxyde de silicium et/ou du nitrure de silicium.

21. Composant selon l'une des revendications précédentes, le matériau non métallique de ladite zone (109, 209, 309) comportant du silicium dopé dont la résistivité est inférieure à environ 1 Ohm.cm.

22. Procédé de réalisation d'un composant comportant au moins une puce (100, 200, 300) destinée à être reportée sur un support (400) et reliée, au niveau d'au moins un emplacement de connexion (102, 202, 302) de la puce (100, 200, 300), à au moins un emplacement de connexion (402) du support (400) par au moins une bille (216, 316), **caractérisé en ce qu'**il comporte au moins les étapes de :
- réalisation d'au moins une tranchée (114, 214, 314) dans au moins une première couche (104, 204, 308), communiquant avec au moins une partie d'une couche sacrificielle (203, 306) disposée contre la première couche (104, 204, 308) et entourant en partie une portion (108, 208) de la première couche (104, 204, 308) tel qu'au moins une zone (109, 209, 309) de ladite couche relie ladite portion (108, 208) de la couche au reste de cette couche,
- suppression de la partie de la couche sacrificielle (203, 306), formant au moins une cavité (110, 210, 310) enterrée et disposée sous au moins la portion (108, 208) de la première couche (104, 204, 308) correspondant à l'emplacement de connexion (102, 202, 302) de la puce (100, 200, 300),
la tranchée (114, 214, 314), la cavité (110, 210, 310) et ladite zone (109, 209, 309) de la couche formant des moyens de découplage mécanique de l'emplacement de connexion (102, 202, 302) de la puce (100, 200, 300) par rapport à la puce (100, 200, 300), ladite zone (109, 209, 309) de la couche étant à base d'au moins un matériau non métallique.

23. Procédé de réalisation d'un composant comportant au moins un support (400) sur lequel une puce (100, 200, 300) est destinée à être reportée et reliée, au niveau d'au moins un emplacement de connexion (102, 202, 302) de la puce (100, 200, 300), à au moins un emplacement de connexion (402) du support (400) par au moins une bille (216, 316), **caractérisé en ce qu'**il comporte au moins les étapes de :
- réalisation d'au moins une tranchée (114, 214, 314) dans au moins une première couche (404), communiquant avec au moins une partie d'une couche sacrificielle (203, 306) disposée contre la première coche (404) et entourant en partie une portion (108, 208) de la première couche (404) tel qu'au moins une zone (109, 209, 309) de ladite couche relie ladite portion (108, 208) de la couche au reste de cette couche,
- suppression de la partie de la couche sacrificielle (203, 306), formant au moins une cavité (110, 210, 310) enterrée et disposée sous au moins la portion (108, 208) de la première couche (404) correspondant à l'emplacement de connexion (402) du support (400),
la tranchée (114, 214, 314), la cavité (110, 210, 310) et ladite zone (109, 209, 309) de la couche formant des moyens de découplage mécanique de l'emplacement de connexion (402) du support (400) par rapport au support (400), ladite zone (109, 209, 309) de la couche étant à base d'au moins un matériau non métallique.

24. Procédé selon les revendications 22 et 23, la puce (100, 200, 300) et le support (400) comportant des emplacements de connexion (102, 202, 302, 402) découplés mécaniquement.

25. Procédé selon l'une des revendications 22.à 24, dans lequel la couche sacrificielle est la couche diélectrique (306) d'un substrat SOI.

26. Procédé selon l'une des revendications 22 à 25, comportant en outre une étape de réalisation d'une portion (112, 212, 312) d'un matériau conducteur disposée sur la portion (108, 208, 302) de la première couche (104, 204, 308).

27. Procédé selon l'une des revendication 22 à 26, comportant en outre, entre l'étape de suppression de la partie de la couche sacrificielle (203) et une étape de report de la puce (100, 200, 300) sur le support (400), une étape de remplissage de la cavité (110, 210, 310) et/ou de la tranchée (114, 214, 314) par un matériau plastique et/ou visqueux.

28. Procédé selon l'une des revendications 22 à 27, comportant en outre, après une étape de report de la puce (100, 200, 300) sur le support (400), une étape de dépôt d'une résine d'enrobage sur le composant électronique.

## Claims

1. Component comprising at least one chip (100, 200, 300) intended to be transferred onto a support (400) and connected at at least one connection location (102, 202, 302) of the chip formed by at least one portion (108, 208) of a layer (104, 204, 308) of the chip, to at least one connection location (402) of the support formed by at least one portion of a layer (404) of the support, through at least one ball (216, 316), the chip comprising mechanical decoupling means of the chip connection location (102, 202, 302) from the chip, **characterized in that** the mechanical decoupling means are formed by at least one cavity (110, 210, 310) buried and made in a sacrificial layer (203, 306), corresponding to a dielectric layer of a SOI substrate or a metallic layer, placed in contact with the layer (104, 204, 308) of the chip, under said connection location (102, 202, 302), and at least one trench (114, 214, 314), made in said layer (104, 204, 308), communicating with said cavity (110, 210, 310) and partly surrounding said portion (108, 208) of the layer (104, 204, 308) such that at least one zone (109, 209, 309) of said layer connects said portion (108, 208) of the layer to the remainder of this layer and being made from at least one non-metallic material.

2. Component comprising at least one support (400) onto which at least one chip (100, 200, 300) is intended to be transferred and connected at at least one connection location (102, 202, 302) of the chip formed by at least one portion (108, 208) of a layer (104, 204, 308) of the chip, to at least one connection location (402) of the support formed by at least one portion of a layer (404) of the support, through at least one ball (216, 316), the support comprising mechanical decoupling means of the support connection location (402) from the support, **characterized in that** the mechanical decoupling means are formed by at least one cavity (110, 210, 310) buried and made in a sacrificial layer (203, 306), corresponding to a dielectric layer of a SOI substrate or a metallic layer, placed in contact with the layer (404) of the support, under said connection location (402), and at least one trench (114, 214, 314), made in said layer (404), communicating with said cavity (110, 210, 310) and partly surrounding said portion (108, 208) of the layer (404) such that at least one zone (109, 209, 309) of said layer connects said portion (108, 208) of the layer to the remainder of this layer and being made from at least one non-metallic material.

3. Component according to claims 1 and 2, in which the chip (100, 200, 300) and the support (400) comprise connection locations (102, 202, 302, 402) which are mechanically decoupled.

4. Component according to any one of previous claims, the trench (114, 214, 314) being arranged around the periphery of the connection location (102, 202, 302) of the chip (100, 200, 300) and/or the connection locations (402, of the support (400).

5. Component according to any one of the previous claims, the trench (114, 214, 314) making the cavity (110, 210, 310) communicate with one face (106, 206) of the layer (104, 204, 308, 404) of the chip and/or the support.

6. Component according to any one of the previous claims, the portion (108, 208) of the layer (104, 204, 308) of the chip (100, 200, 300) and/or the portion of the layer (404) of the support (400) being approximately polygonal in shape or being in the shape of a disk in a plane parallel to a principal plane of the layer (104, 204, 308) of the chip and/or the layer (404) of the support (400).

7. Component according to any one of the previous claims, the trench (114, 214, 314) comprising a shape chosen from among a rectangular pattern and a circle arc pattern in a plane parallel to a principal plane of the layer (104, 204, 308) of the chip and/or the layer (404) of the support (400).

8. Component according to any one of the previous claims, the mechanical decoupling means comprising at least four trenches (114, 214, 314) made in the layer (104, 204, 308) of the chip and/or the layer (404) of the support, making the cavity (110, 210, 310) communicate with a face (106, 206) of the layer (104, 204, 308) of the chip and/or the layer (404) of the support.

9. Component according to any one of the previous claims, the trench comprising at least one comb pattern.

10. Component according to any one of the previous claims, the mechanical decoupling means also comprising at least one plastic and/or viscous material arranged in at least part of the trench (114, 214, 314) and/or the cavity (110, 210, 310).

11. Component according to any one of the previous claims, the connection location (102, 202, 302) of the chip (100, 200, 300) and/or the connection location (402) of the support (400) comprising at least one portion (112, 212, 312) of an electrically conducting material, arranged on the portion (108, 208, 302) of the layer (104, 204, 308, 404) of the chip and/or the support.

12. Component according to claim 11, the portion (112, 212, 312) of conducting material forming an electrical contact between at least two elements of the component.

13. Component according to one of claims 11 or 12, also comprising at least one metallic track made on the chip (100, 200, 300) and/or the support (400) and electrically connected to the portion (112, 212, 312) of conducting material.

14. Component according to any one of claims 11 to 13, the portion (112, 212, 312) of conducting material forming at least one part of an electrical contact between the chip (100, 200, 300) and the support (400).

15. Component according to any one of the previous claims, the chip (100, 200, 300) comprising at least one MOS type device and/or at least one MEMS and/or at least one NEMS and/or at least one MOEMS (301).

16. Component according to any one of the previous claims, the chip (100, 200, 300) being electrically connected to the support (400) through the ball (216, 316).

17. Component according to any one of the previous claims, the mechanical decoupling means performing mechanical filtering between the chip (100, 200, 300) and the support (400).

18. Component according to any one of the previous claims, the chip (100, 200, 300) being made from a material for which the coefficient of thermal expansion is different from the coefficient of thermal expansion of the material from which the support is made (400).

19. Component according to any one of the previous claims, also comprising a material embedding the chip (100, 200, 300) and/or the support (400).

20. Component according to any one of the previous claims, the non-metallic material of said zone (109, 209, 309) comprising silicon and/or silicon oxide and/or silicon nitride.

21. Component according to any one of the previous claims, the non-metallic material of said zone (109, 209, 309) comprising doped silicon with a resistivity of less than about 1 Ohm.cm.

22. Method of making a component comprising at least one chip (100, 200, 300) intended to be transferred onto a support (400) and connected, at at least one connection location (102, 202, 302) of the chip (100, 200, 300), to at least one connection location (402) of the support (400) through at least one ball (216, 316), **characterized in that** it comprises at least the following steps:
- make at least one trench (114, 214, 314) in at least one first layer (104, 204, 308), communicating with at least part of a sacrificial layer (203, 306) placed in contact with the first layer (104, 204, 308) and partly surrounding a portion (108, 208) of the first layer (104, 204, 308) such that at least one zone (109, 209, 309) of said layer connects said portion (108, 208) of the layer to the rest of this layer;
- eliminate part of the sacrificial layer (203, 306), forming at least one buried cavity (110, 210, 310) and arranged under at least the portion (108, 208) of the first layer (104, 204, 308) corresponding to the connection location (102, 202, 302) of the chip (100, 200, 300);
the trench (114, 214, 314), cavity (110, 210, 310) and said zone (109, 209, 309) of the layer forming mechanical decoupling means of the connection location (102, 202, 302) of the chip (100, 200, 300) from the chip (100, 200, 300), said zone (109, 209, 309) of the layer being made from at least one non-metallic material.

23. Method of making a component comprising at least one support (400) onto which a chip (100, 200, 300) is intended to be transferred and connected, at at least one connection location (102, 202, 302) of the chip (100, 200, 300), to at least one connection location (402) of the support (400) through at least one ball (216, 316), **characterized in that** it comprises at least the following steps:
- make at least one trench (114, 214, 314) in at least one first layer (404), communicating with at least part of a sacrificial layer (203, 306) placed in contact with the first layer (404) and partly surrounding a portion (108, 208) of the first layer (404) such that at least one zone (109, 209, 309) of said layer connects said portion (108, 208) of the layer to the rest of this layer;
- eliminate part of the sacrificial layer (203, 306), forming at least one buried cavity (110, 210, 310) and arranged under at least the portion (108, 208) of the first layer (404) corresponding to the connection location (402) of the support (400);
the trench (114, 214, 314), cavity (110, 210, 310) and said zone (109, 209, 309) of the layer forming mechanical decoupling means of the connection location (402) of the support (400) from the support (400), said zone (109, 209, 309) of the layer being made from at least one non-metallic material.

24. Method according to claims 22 and 23, the chip (100, 200, 300) and the support (400) comprising connection locations (102, 202, 302, 402) which are mechanically decoupled.

25. Method according to any one of claims 22 to 24, in which the sacrificial layer is the dielectric layer (306) of a SOI substrate.

26. Method according to any one of claims 22 to 25, also comprising a step to make a portion (112, 212, 312) of a conducting material arranged on the portion (108, 208, 302) of the first layer (104, 204, 308).

27. Method according to any one of claims 22 to 26, also comprising a cavity (110, 210, 310) and/or trench (114, 214, 314) filling step with a plastic and/or viscous material, between the step to eliminate the part of the sacrificial layer (203) and a step to transfer the chip (100, 200, 300) onto the support (400).

28. Method according to any one of claims 22 to 27, also comprising a step to deposit a coating resin on the electronic component, after a step to transfer the chip (100, 200, 300) onto the support (400).

## Patentansprüche

1. Komponente mit mindestens einem Chip (100,200,300), der auf einen Träger (400) zu übertragen ist und an mindestens einer Verbindungsstelle (102,202,302) des Chips, die aus mindestens einem Abschnitt (108,208) einer Schicht (104,204,308) des Chips besteht, über mindestens eine Kugel (216,316) mit mindestens einer Verbindungsstelle (402) des Trägers, die aus mindestens einem Abschnitt einer Schicht (404) des Trägers besteht, zu verbinden ist, wobei der Chip Mittel zum mechanischen Entkoppeln der Verbindungsstelle (102,202,302) des Chips bezüglich des Chips aufweist, **dadurch gekennzeichnet, dass** die Mittel zum mechanischen Entkoppeln bestehen aus:
mindestens einem vergrabenen Hohlraum (110,210,310), der in einer an die Schicht (104,204,308) des Chips angrenzenden Opferschicht (203,306), die einer dielektrischen Schicht eines SOI-Substrats oder einer metallischen Schicht entspricht, unterhalb der Verbindungsstelle (102,202,303) gebildet ist, und
mindestens einem in der Schicht (109,204,308) gebildeten Graben (114,214,314), der mit dem Hohlraum (110,210,310) in Verbindung steht und den Abschnitt (108,208) der Schicht (104,204,308) teilweise umgibt, so dass mindestens eine Zone (109,209,309) der Schicht den Abschnitt (108,208) der Schicht mit dem Rest dieser Schicht verbindet, wobei die Zone (109,209,309) auf Basis mindestens eines nichtmetallischen Materials ist.

2. Komponente mit mindestens einem Träger (400), auf welchen mindestens ein Chip (100,200,300) zu übertragen ist, der an mindestens einer Verbindungsstelle (102,202,302) des Chips, die aus mindestens einem Abschnitt (108,208) einer Schicht (104,204,308) des Chips besteht, über mindestens eine Kugel (216,316) mit mindestens einer Verbindungsstelle (402) des Trägers, die aus mindestens einem Abschnitt einer Schicht (404) des Trägers besteht, zu verbinden ist, wobei der Träger Mittel zum mechanischen Entkoppeln der Verbindungsstelle (402) des Trägers bezüglich des Trägers aufweist, **dadurch gekennzeichnet, dass** die Mittel zum mechanischen Entkoppeln bestehen aus:
mindestens einem vergrabenen Hohlraum (110,210,310), der in einer an die Schicht (404) des Trägers angrenzenden Opferschicht (203,306), die einer dielektrischen Schicht eines SOI-Substrats oder einer metallischen Schicht entspricht, unterhalb der Verbindungsstelle (402) gebildet ist, und
mindestens einem in der Schicht (404) gebildeten Graben (114,214,314), der mit dem Hohlraum (110,210,310) in Verbindung steht und den Abschnitt (108,208) der Schicht (404) teilweise umgibt, so dass mindestens eine Zone (109,209,309) der Schicht den Abschnitt (108,208) der Schicht mit dem Rest dieser Schicht verbindet, wobei die Zone (109,209,309) auf Basis mindestens eines nichtmetallischen Materials ist.

3. Komponente nach Anspruch 1 und 2, wobei der Chip (100,200,300) und der Träger (400) mechanisch entkoppelte Verbindungsstellen (102,202,302,402) aufweisen.

4. Komponente nach einem der vorstehenden Ansprüche, wobei der Graben (114,214,314) an der Peripherie der Verbindungsstelle (102,202,303) des Chips (100,200,300) und/oder der Verbindungsstelle (402) des Trägers (400) angeordnet ist.

5. Komponente nach einem der vorstehenden Ansprüche, wobei der Graben (114,214,314) den Hohlraum (110,210,310) mit einer Fläche (106,206) der Schicht (104,204,308,404) des Chips und/oder des Trägers verbindet.

6. Komponente nach einem der vorstehenden Ansprüche, wobei in einer Ebene, die parallel zu einer Hauptebene der Schicht (104,204,308) des Chips und/oder der Schicht (404) des Trägers (400) ist, der Abschnitt (108,208) der Schicht (104,204,308) des Chips (100,200,300) und/oder der Abschnitt der Schicht (404) des Trägers (400) eine im Wesentlichen polygonale Form oder eine Scheibenform aufweist.

7. Komponente nach einem der vorstehenden Ansprüche, wobei in einer Ebene, die parallel zu einer Hauptebene der Schicht (104,204,308) des Chips und/oder der Schicht (404) des Trägers (400) ist, der Graben (114,214,314) eine Form aufweist, die ausgewählt ist aus einem rechteckigen Motiv und einem Kreisbogenmotiv.

8. Komponente nach einem der vorstehenden Ansprüche, wobei die Mittel zum mechanischen Entkoppeln mindestens vier Gräben (114,214,314) aufweisen, die in der Schicht (104,204,308) des Chips und/oder der Schicht (404) des Trägers gebildet sind und den Hohlraum (110,210,310) mit einer Fläche (106,206) der Schicht (104,204,308) des Chips und/oder der Schicht (404) des Trägers verbinden.

9. Komponente nach einem der vorstehenden Ansprüche, wobei der Graben mindestens ein Kammmotiv aufweist.

10. Komponente nach einem der vorstehenden Ansprüche, wobei die Mittel zum mechanischen Entkoppeln außerdem mindestens ein Kunststoff- und/oder viskoses Material aufweisen, das in mindestens einem Teil des Grabens (114,214,314) und/oder des Hohlraums (110,210,310) angeordnet ist.

11. Komponente nach einem der vorstehenden Ansprüche, wobei die Verbindungsstelle (102,202,302) des Chips (100,200,300) und/oder die Verbindungsstelle (402) des Trägers (400) mindestens einen Abschnitt (112,212,312) eines elektrisch leitenden Materials aufweist, das an dem Abschnitt (108,208,302) der Schicht (104,204,308,404) des Chips und/oder des Trägers angeordnet ist.

12. Komponente nach Anspruch 11, wobei der Abschnitt (112,212,312) des leitenden Materials einen elektrischen Kontakt zwischen mindestens zwei Elementen der Komponente bildet.

13. Komponente nach einem der Ansprüche 11 oder 12, außerdem mit mindestens einer metallischen Bahn, die an dem Chip (100,200,300) und/oder dem Träger (400) gebildet ist und mit dem Abschnitt (112,212,312) des leitenden Materials elektrisch verbunden ist.

14. Komponente nach einem der Ansprüche 11 bis 13, wobei der Abschnitt (112,212,312) des leitenden Materials mindestens einen Teil eines elektrischen Kontakts zwischen dem Chip (100,200,300) und dem Träger (400) bildet.

15. Komponente nach einem der vorstehenden Ansprüche, wobei der Chip (100,200,300) außerdem mindestens eine Vorrichtung des Typs MOS und/oder mindestens ein MEMS und/oder mindestens ein NEMS und/oder mindestens ein MOEMS (301) aufweist.

16. Komponente nach einem der vorstehenden Ansprüche, wobei der Chip (100,200,300) über die Kugel (216,316) elektrisch mit dem Träger (400) verbunden ist.

17. Komponente nach einem der vorstehenden Ansprüche, wobei die Mittel zum mechanischen Entkoppeln eine mechanische Filterung zwischen dem Chip (100,200,300) und dem Träger (400) verwirklichen.

18. Komponente nach einem der vorstehenden Ansprüche, wobei der Chip (100,200,300) auf Basis eines Materials hergestellt ist, dessen Wärmeausdehnungskoeffizient sich von demjenigen eines Materials, aus welchem der Träger (400) besteht, unterscheidet.

19. Komponente nach einem der vorstehenden Ansprüche, außerdem mit einem Material, das den Chip (100,200,300) und/oder den Träger (400) umhüllt.

20. Komponente nach einem der vorstehenden Ansprüche, wobei das nichtmetallische Material der Zone (109, 209, 309) Silizium und/oder Siliziumoxid und/oder Siliziumnitrid aufweist.

21. Komponente nach einem der vorstehenden Ansprüche, wobei das nichtmetallische Material der Zone (109,209,309) dotiertes Silizium aufweist, dessen Resistivität kleiner ist als ungefähr 1 Ohm*cm.

22. Verfahren zur Herstellung einer Komponente, die mindestens einen Chip (100,200,300) aufweist, der auf einen Träger (400) zu übertragen ist und an mindestens einer Verbindungsstelle (102,202,302) des Chips (100,200,300) über mindestens eine Kugel (216,316) mit mindestens einer Verbindungsstelle (402) des Trägers (400) zu verbinden ist, **dadurch gekennzeichnet, dass** es mindestens die folgenden Schritte aufweist:
- Herstellung mindestens eines Grabens (114,214,314) in mindestens einer ersten Schicht (104,204,308), der mit mindestens einem Teil einer an die erste Schicht (104,204,308) angrenzenden Opferschicht (203,306) in Verbindung steht und einen Abschnitt (108,208) der ersten Schicht (104,204,308) teilweise umgibt, so dass mindestens eine Zone (109,209,309) der Schicht den Abschnitt (108,208) der Schicht mit dem Rest dieser Schicht verbindet,
- Beseitigen des Teils der Opferschicht (203,306) die mindestens einen vergrabenen Hohlraum (110,210,310) ausbilden, der unterhalb mindestens des Abschnitts (108,208) der ersten Schicht (104,204,308) angeordnet ist, der der Verbindungsstelle (102,202,302) des Chips (100,200,300) entspricht,
wobei der Graben (114,214,314), der Hohlraum (110,210,310) und die Zone (109,209,309) der Schicht Mittel zum mechanischen Entkoppeln der Verbindungsstelle (102,202,302) des Chips (100,200,300) bezüglich des Chips (100,200,300) bilden, wobei die Zone (109,209,309) der Schicht auf Basis mindestens eines nichtmetallischen Materials ist.

23. Verfahren zur Herstellung einer Komponente, die mindestens einen Träger (400) aufweist, auf welchen ein Chip (100,200,300) zu übertragen ist, der an mindestens einer Verbindungsstelle (102,202,302) des Chips (100,200,300) über mindestens eine Kugel (216,316) mit mindestens einer Verbindungsstelle (402) des Trägers (400) zu verbinden ist, **dadurch gekennzeichnet, dass** es mindestens die folgenden Schritte aufweist:
- Herstellung mindestens eines Grabens (114,214,314) in mindestens einer ersten Schicht (404), der mit mindestens einem Teil einer an die erste Schicht (404) angrenzenden Opferschicht (203,306) in Verbindung steht und teilweise einen Abschnitt (108,208) der ersten Schicht (404) umgibt, so dass mindestens eine Zone (109,209,309) der Schicht den Abschnitt (108,208) der Schicht mit dem Rest dieser Schicht verbindet,
- Beseitigen des Teils der Opferschicht (203,306) die mindestens einen vergrabenen Hohlraum (110,210,310) ausbilden, der unterhalb mindestens des Abschnitts (108,208) der ersten Schicht (404) angeordnet ist, der der Verbindungsstelle (402) des Trägers (400) entspricht,
wobei der Graben (114,214,314), der Hohlraum (110,210,310) und die Zone (109,209,309) der Schicht Mittel zum mechanischen Entkoppeln der Verbindungsstelle (402) des Trägers (400) bezüglich des Trägers (400) bilden, wobei die Zone (109,209,309) der Schicht auf Basis mindestens eines nichtmetallischen Materials ist.

24. Verfahren nach Anspruch 22 und 23, wobei der Chip (100,200,300) und der Träger (400) mechanisch entkoppelte Verbindungsstellen (102,202,302,402) aufweisen.

25. Verfahren nach einem der Ansprüche 22 bis 24, in welchem die Opferschicht die dielektrische Schicht (306) eines SOI-Substrats ist.

26. Verfahren nach einem der Ansprüche 22 bis 25, das außerdem einen Schritt der Herstellung eines Abschnitts (112,212,312) eines leitenden Materials aufweist, der an dem Abschnitt (108,208,302) der ersten Schicht (104,204,308) angeordnet ist.

27. Verfahren nach einem der Ansprüche 22 bis 26, das zwischen dem Schritt der Beseitigung des Teils der Opferschicht (203) und einem Schritt der Übertragung des Chips (100,200,300) auf den Träger (400) außerdem einen Schritt des Füllens des Hohlraums (110,210,310) und/oder des Grabens (114,214,314) mit einem Kunststoff- und/oder viskosen Material aufweist.

28. Verfahren nach einem der Ansprüche 22 bis 27, das nach einem Schritt der Übertragung des Chips (100,200,300) auf den Träger (400) einen Schritt des Aufbringens eines Umhüllungsharzes auf die elektronische Komponente aufweist.
